# EUROPEAN PATENT APPLICATION

(11) **EP 1 498 919 A2**
(43) Date of publication of application: **19.01.2005**
(21) Application number: 04254174.8
(22) Date of filing: 13.07.2004
(51) Int. Cl.: H01F 41/30, H01F 10/32

(54) **Manufacturing a magnetic cell**

(30) Priority: 16.07.2003 US 621125
(71) Applicant: Hewlett-Packard Development Company, L.P., Houston, TX 77070 (US)
(72) Inventor: Sharma, Manish, Sunnyvale, CA 94086 (US)
(74) Representative: Powell, Stephen David

(57) **Abstract**

A method of developing growth of <111> crystal texture within at least one layer of composition (at least 21-25) of a magnetic memory cell (at least 20, 80) comprises applying the at least one layer of composition with a level of ion that is sufficiently high to enable alignment of the at least one layer of composition to a high degree of quality for the <111> crystal texture.

## Description

The present invention relates generally to magnetic cells and particularly to magneto resistive storage devices. More particularly, the present invention relates to the development of a high quality <111> crystal texture within a magnetic memory cell of of a Magnetic Random Access Memory (MRAM) device.

It has been recognized that it would be advantageous to develop a magnetic memory cell having high quality <111> crystal texture throughout the junction.

The invention provides a method of developing growth of <111> crystal texture within at least one layer of composition of a magnetic memory cell, the method comprising applying the at least one layer of composition within the memory cell with a level of ion energy that is sufficiently high to enable alignment of the at least one layer of composition to a high degree of quality for the <111> crystal texture.

Additional features and advantages of the invention will be apparent from the detailed description which follows, taken in conjunction with the accompanying drawings, which together illustrate, by way of example, features of the invention.
FIG. 1 is a flow chart diagramming the method used to develop the <111> crystal texture in a top-spin valve structure;
FIG. 2 is a cross-sectional view of the top-spin valve structure described in FIG. 1;
FIG. 3 is a plot demonstrating how the level of ion energy affects the hysteresis loop of a TMR junction.
FIG. 4 is a flow chart diagramming the method used to determine the level of ion energy that is sufficiently high to enable alignment to a high degree of quality for the <111> crystal texture;
FIG. 5 is a cross-sectional view of a synthetic ferrimagnet;
FIG. 6 is a cross-sectional view of a top-spin valve structure where the ferromagnetic layers have been replaced with synthetic ferrimagnets;
FIG. 7 is a flow chart diagramming the method used to develop the <111> crystal texture in a bottom-spin valve structure; and
FIG. 8 is a cross-sectional view of the bottom-spin valve structure described in FIG. 7.

Reference will now be made to the exemplary embodiments illustrated in the drawings, and specific language will be used herein to describe the same. It will nevertheless be understood that no limitation of the scope of the invention is thereby intended. Alterations and further modifications of the inventive features illustrated herein, and additional applications of the principles of the inventions as illustrated herein, which would occur to one skilled in the relevant art and having possession of this disclosure, are to be considered within the scope of the invention.

In accordance with the present invention, a method is disclosed which develops growth of a high quality of <111> crystal texture within at least one layer of composition of a magnetic memory cell. The method is comprised of applying the at least one layer of composition within the memory cell with a level of ion energy that is sufficiently high to enable alignment of the at least one layer of composition to a high degree of quality for the <111> crystal texture. While this method is aimed particularly at developing a high degree of quality for the <111> crystal texture within magnetic memory cells, the disclosed method may apply to various other magnetic sensing applications. For example, a magnetic read head used for sensing the magnetic field of a hard drive may benefit from employing the disclosed method. This is especially true now that many magnetic sense heads are using TMR junctions as the sensor.

While the above method is applicable to developing a high degree of quality for the <111> crystal texture in all layers of composition within magnetic memory cells, the method is especially advantageous in tunneling magneto resistive (TMR) junctions (also known as magnetic tunneling junctions, or MTJs). In TMR junctions, a tunneling barrier layer either terminates completely or attenuates to a large degree the continued propagation of the <111> crystal texture field from below into the layers above it. By applying the layer of composition above the tunneling barrier layer using high levels of ion energy, the layer above the tunneling barrier develops the <111> crystal texture despite the existence of the tunneling barrier layer. Thus, if a top-spin valve structure were fabricated, where the FM pinned layer and the pinning layer are above the oxide layer, the FM pinned layer and the pinning layer would have very poor <111> crystal texture. Likewise, if a bottom-spin valve structure were fabricated, where the sense layer is above the oxide layer, the FM sense layer would have very poor <111 > crystal texture.

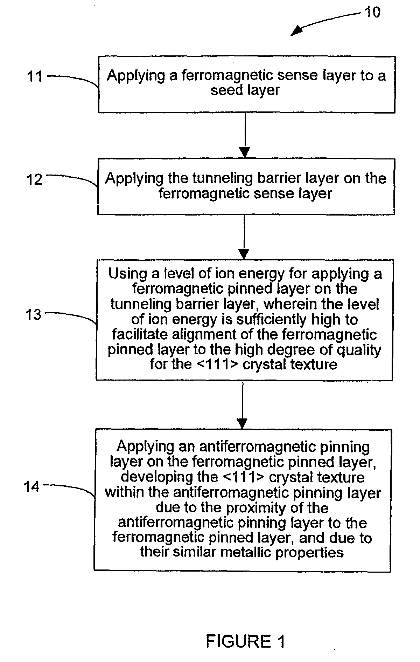

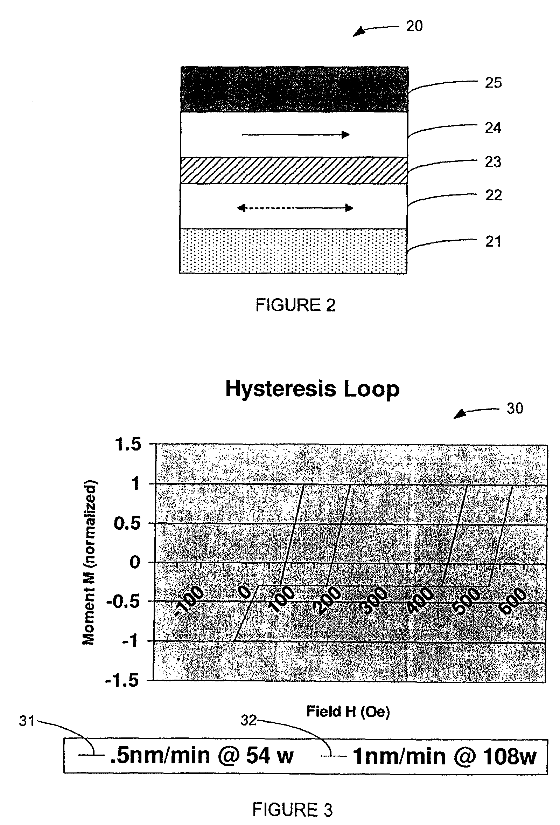

As illustrated in FIG. 1 and FIG. 2, a method 10 in accordance with the present invention is shown for manufacturing a top-spin valve TMR junction 20 such that a high degree of quality of <111> crystal texture is established within layers of composition of the TMR junction. First, the seed layer 21, which establishes the growth of subsequent layers in a <111> crystal texture orientation, and the FM sense layer 22 are applied 11. The FM sense layer 22 may assume the <111> crystal texture established by the seed layer 21. The magnetization vector of the FM sense layer 22 is free to switch orientations, as indicated by the dotted arrow in FIG. 2. The FM sense layer 22 is also referred to as the data layer, because the direction of its magnetization vector determines the value of the data bit stored in the TMR junction 20.

Second, the tunneling barrier layer 23 is applied 12 on the FM sense layer 22. The tunneling barrier layer 23 allows quantum mechanical tunneling to occur between FM sense layer 22 and FM pinned layer 24. This tunneling phenomenon is electron spin dependent, causing resistance of the magnetic tunnel junction to be a function of the relative orientations of the magnetization vectors of the FM pinned layer 24 and the FM sense layer 22. The tunneling barrier layer 23 is grown in an amorphous fashion, which causes the <111> crystal texture of the layers grown above it to be inferior to the layers below it.

Third, an FM pinned layer 24 is applied 13 on the tunneling barrier layer 23 using a level of ion energy that is sufficiently high to facilitate alignment of the FM pinned layer 24 to the high degree of quality for the <111> crystal texture

Fourth, the pinning layer 25 is formed 14 on the FM pinned layer 24. The FM pinning layer 25 may also be applied using high levels of ion energy. The pinning layer 25 does not have a magnetization of its own, but instead forces the magnetization vector of the FM pinned layer 24 to be fixed in one orientation. The pinning layer 25 may be formed from an antiferromagnetic (AFM) material. It is important that the F'M pinned layer and the AFM pinning layer establish a high degree of <111> crystal texture because the <111> crystal texture in the pinning 25 and pinned layers 24 creates strong exchange bias for the pinning 25 and pinned layers 24. The strong exchange bias is what forces the FM pinned layer 24 to be fixed in one direction.

As illustrated in FIG. 3, the hysteresis loop 30 of a TMR junction can be altered depending on the level of ion energy used to deposit the AFM pinning layer and the FM pinned layer. A hysteresis loop is a description of the magnetic field strengths required to change the magnetic orientation of a ferromagnetic substance. In FIG. 3, the AFM pinning layer and the FM pinned layer of one TMR junction were deposited using an energy level of 54 Watts 31, while the AFM pinning layer and the FM pinned layer of a second TMR junction were deposited using an energy level of 108 Watts 32. As a result, the magnetic field required to change the magnetic orientation of the FM pinned layer deposited at 108 W was approximately 100 Oe more than for the FM pinned layer deposited at 54 W. This increase occurs because of the better <111> crystal texture that was established in the AFM pinning layer and the FM pinned in the second TMR junction due to the higher energy levels used when depositing its FM pinned layer. The resultant <111> crystal texture creates a strong exchange bias for the pinned and pinning layers, which causes the pinned layer's magnetic orientation to be "pushed", or "fixed" in one orientation. Because this "push" is higher in the FM pinned layer deposited at 108 W than it is in the FM pinned layer deposited at 54 W, it requires a higher magnetic field to change the magnetization vector of the FM pinned layer deposited at 108 W. This is a very desirable result in a pinned layer, since it's purpose is to be fixed in one direction so that it can be used as a reference layer in relation to the FM sense layer.

This invention discloses that the degree of <111> crystal texture obtained in the layers of composition of a magnetic memory cell is a function of the level of ion energy used during the deposition of those layers. This is especially important when depositing layers above the tunneling barrier layer, because the tunneling barrier either terminates completely or attenuates to a large degree the continued propagation of the <111> crystal texture field from below into the layers above it. The general principle is that the higher the level of ion energy used during the deposition of layers within a magnetic memory cell, the better the resultant <111> crystal texture in those layers will be. This general principle holds true up until the point where the level of ion energy is so high that the atoms for the new layer are knocking atoms in the previous layer out of position instead of migrating into position. In other words, the levels of ion energy used are too high when the process stops depositing new layers, and begins etching away previous layers.

The level of ion energy needed to obtain effective <111> crystal texture will vary with each deposition system. It may be possible to define the specific power level that constitutes "high levels of ion energy" but this will be very specific to each deposition system. Factors that may affect the optimal level of ion energy can include the dimensions of the deposition system, the dimensions of the target, and the distance between the deposition system and the target. However, the general principle that higher levels of ion energy result in better <111> crystal texture holds true irrespective of what type of deposition system is being used.

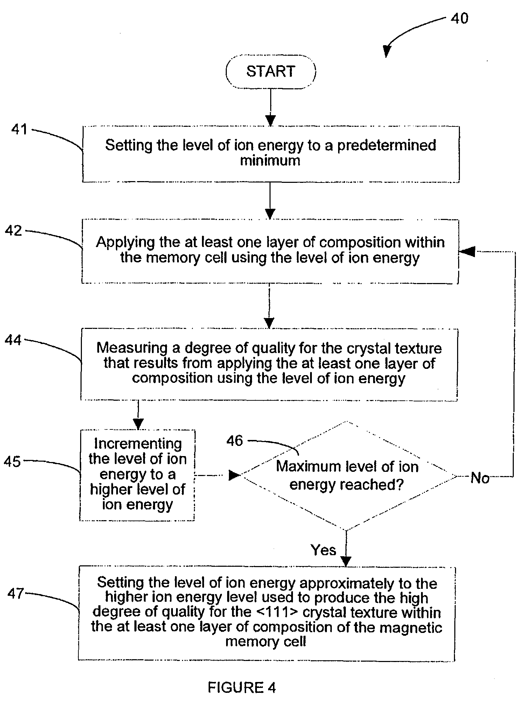

As illustrated in FIG. 4, a method 40 in accordance with the present invention is shown for finding the level of ion energy that is sufficiently high to enable alignment of the at least one layer of composition to the high degree of quality for the <111> crystal. First, the level of ion energy used for depositing the layers of composition is set 41 to a predetermined minimum level. Second, at least at least one layer of composition is applied 42 within the memory cell using the level of ion energy set in step one. The layer of composition may consist of an FM layer. At least a tunneling barrier layer may be deposited within the memory cell prior to applying the at least one layer of composition using the level of ion energy. Third, a degree of quality for the <111> crystal texture that results from applying the at least one layer of composition using the level of ion energy is measured 44. Fourth, the level of ion energy is incremented 45 to a higher ion energy level by a predetermined amount. The process is repeated 46 from the second step until a desired ion energy level has been reached. Finally, when the predetermined maximum level of ion energy level has been reached, the level of ion energy is set 47 to approximately the higher level of ion energy used to produce the high degree of quality for the <111> crystal texture within the at least one layer of composition of the magnetic memory cell. The sufficiently high level of ion energy can either be a level that produced a high degree of quality for the <111> crystal texture, or can be the level that produced the highest degree of quality that was measured for the <111> crystal texture, depending on the needs of the manufacturer. This process can be slightly altered, and is equally effective and applicable to top-spin valve TMR structures as well as bottom-spin valve TMR structures, discussed in detail below.

The use of a top-spin valve structure enables the FM sense layer 22 to be grown directly on top of the seed layer 21. Consequently, the structure is much smoother than it would otherwise be in a bottom-spin valve structure where the sense layer 22 is grown above the tunneling barrier layer 23. This result provides for greater uniformity and greater controlled magnetic properties. When the stress or roughness of the sense layer surface is reduced, magnetostriction and magnetic anisotropy are also reduced. Further, the sense layer 22 can now be placed closer to the bottom conductor word. line of the bottom electrode, improving its response to electrical pulses in the bottom conductor word line. This provides for a more efficient bit switching and reduces switching field requirements. This is all achieved by depositing the magnetic layers of FM layers above the tunneling barrier layer at high ion energies

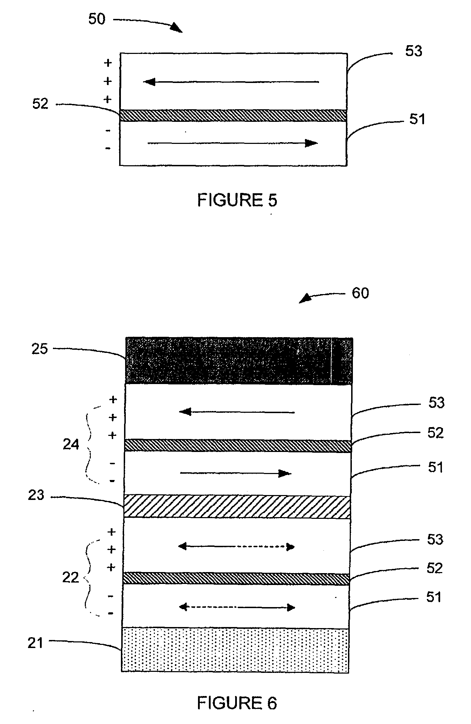

The technique of depositing layers within a magnetic memory cell using high levels of ion energy is also beneficial when an FM layer is replaced with a synthetic ferrimagnet (SF). As illustrated in FIG. 5, the most basic SF layer 50 consists of two FM layers 51 and 53. The first FM layer 51 is separated from the second FM layer 53 by a thin non-magnetic spacer layer 52. The spacer layer 52 has properties such that the two FM layers 51 and 53 are strongly exchange-coupled to each other. This coupling causes them to align in opposite directions as noted by the directional arrows in each layer to produce a net zero or close to zero magnetization. While this tri-layer structure is the simplest form of an SF layer, more than two FM layers, each separated by a spacer, also create an SF structure. In this case, the magnetizations are oriented in opposite directions in adjacent layers: + then - then + again, and so on.

However, it is difficult to achieve a strong exchange-coupling without effective <111> crystal texture. When an SF layer 50 is deposited above the tunneling barrier layer 53, the <111> crystal texture is attenuated or completely eliminated, thereby reducing the exchange-coupling between the two FM layers 51 and 53 in an SF layer 50. By depositing the SF layer 50 at high levels of ion energy, the <111> crystal texture is developed in the SF layer 50. Thus, strong exchange-coupling between the two FM layers 51 and 53 is developed.

One benefit of replacing an FM layer with an SF layer structure 50 is that it reduces the strong demagnetizing fields that are typically produced at the bit edges when the MRAM stack is patterned into a rectangular, oval, or other geometrically useful bit shapes. Since the magnetization vectors of the two layers 51 and 53 are pointed in opposite directions, their net demagnetizing field at the edges is close to zero. Significantly, utilizing an SF layer 50 as the FM sense layer 22 provides improved reduction of the demagnetization field at the boundaries since the hysteresis loop of the FM sense layer 22 is more sensitive to anisotropy contributions from the demagnetizing field. These benefits are maximized when both the FM pinned layer 24 and the FM sense layer 22 are substituted with SF layers 50. FIG. 6 is a cross sectional diagram of a top-spin valve structure TMR junction where both the FM pinned layer 24 and the FM sense layer 22 have been replaced with SF layers 50.

The thicknesses of the two FM layers 51 and 53 and the non-magnetic spacer layer 52 need not be identical in thickness or composition, and actually may deliberately be made different to produce a slightly imbalanced SF layer 50. This imbalanced SF layer 50 has advantages when used as the FM pinned 24 or FM sense layer 22. Since the degree of imbalance can be controlled, the changes in the hysteresis loop, referred to as the R-H characteristics, can be calculated and tailored. By tailoring the R-H characteristics, the switching behavior of the magnetization vectors of the FM layers 51 and 53 can be controlled. This allows for better control over the current used to switch the magnetization vector of the FM sense layer 22.

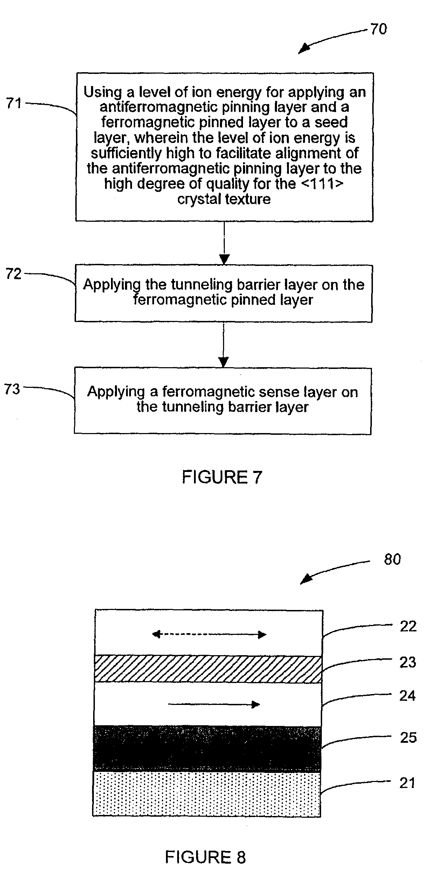

As illustrated in FIG. 7 and FIG. 8, a method 70 in accordance with the present invention is shown for manufacturing a bottom-spin valve TMR junction 80 such that a high degree of quality of <111> crystal texture is established within layers of composition of the TMR junction. First, an antiferromagnetic pinning layer 25 and a ferromagnetic pinned layer 24 are applied 71 to a seed layer 21 using a level of ion energy that is sufficiently high to facilitate alignment of the antiferromagnetic pinning layer and the ferromagnetic pinned layer to the high degree of quality for the <111> crystal texture. Second, the tunneling barrier layer 23 is grown 72 on the FM pinned layer 24. As described above, the tunneling barrier layer 23 normally causes the <111> crystal texture of the layers grown above it to be inferior to the layers below it. Third, the FM sense layer 22 is deposited 73 on the tunneling barrier layer 23. The sense layer 22 may also be deposited using a high level of ion energy. However, it is often desirable that the sense layer not have <111> crystal texture. In such cases, the sense layer would be applied using a normal level of ion energy as opposed to the high level.

The bottom-spin valve structure can also benefit by replacing the FM sense layer 22 and the FM pinned layer 24 with SF layers 30. By replacing these layers with SF layers, their net demagnetizing field at the edges is close to zero. However, it would be difficult to develop the necessary exchange-coupling between the two FM layers 51 and 53 of the SF layer 50 above the tunneling barrier layer 23 were it not for the high levels of ion energy used during its deposition as disclosed in this invention.

The processes for manufacturing TMR structures can include various types of chemical vapor deposition, atomic layer deposition, molecular beam epitaxy, e-beam evaporation, laser ablation, plasma-assisted deposition, as well as other methods suitable for use of high ion energies. The thicknesses of the FM layers can be varied to control the demagnetization required. When FM layers are deposited, alloyed deposition can be performed either from pre-fabricated targets that have the right composition or by codeposition of several materials from more than one target in a controlled ratio. The first layer is typically applied using magnetron sputtering or ion-beam deposition. The processing techniques described above can be utilized for both the bottom-spin valve and the top-spin valve structures.

The materials that can be used for the various layers will now be described in detail. Several different types of materials are utilized to manufacture or fabricate the FM pinned and FM sense layers. The FM pinned layer 24 and the FM sense layer 22 are made of an FM material typically a binary or ternary alloy ofNi, Fe and/or Co. The layers 24 and 22 may be made from the same or different materials. Other potential FM layer materials include doped amorphous ferromagnetic alloys and PERMALLOY™, and doped amorphous FM materials, which are alloys of Ni/Fe/Co doped to various degrees with amorphizing agents such as Nb, B, Hf, Si, and N.

When an SF layer 30 serves as the FM pinned layer 24 or the FM sense layer 22, the SF layer 30 can include a first layer of NiFe, NiFeCo, CoFe, or other magnetically soft alloys of Ni, Fe and Co, a spacer layer of Ru, Re, Rh, or Cu, and a third layer similar to that of the first layer. Doped amorphous FM alloys may also be used.

The AFM pinning layer 25 is typically manufactured from FeMn, NiMn, PtMn, IrMn.

The seed layer 21 actually may serve two purposes. Besides serving as a seed layer, it may also serve as the bottom conductor to provide a path for electrical current to flow during specific operations. The preferred materials for fabricating the seed layer 21 are Cu, Ta, Ta/Ru, Ta, TaN, Ti, TiN, or a multiplayer combination of Ta/NiFe, Ta/Cu, Ta/Ru, Cu/Ru, Ta/Ru, Ta/Cu/Ru, Ta/Ru/FM, Ta/Ru/SF or the like. Ta/NiFe, or Ta/Cu/NiFe multilayers have desirable properties, but they should be avoided. Thus, Ta/SF or Ta/Cu/SF are proposed as viable and useful substitutes but are, not necessarily preferred. Since Ru is completely non-magnetic, all the demagnetizing field problems are eliminated when it is used as the seed layer. An added benefit of using Ru is that it stops any interaction between the Ta and the FM or SF layer. Typically, an interaction occurs between the Ta and the adjacent magnetic layer and leads to a loss of moment of the magnetic layer and also reduced thermal stability of the device (both undesirable in terms of uniformity of properties in manufacturing and also for long-term reliability).

The seed layer materials are selected because of their ability to promote subsequent growth of films with <111> crystal texture that provides effective anisotropy in the NiFe FM layers or a high pinning field from the AFM pinning layer. This allows for the subsequent deposition of a layer of NiFe or an SF layer on the seed layer to have higher <111> orientation of its crystal texture. This growth orientation is needed to achieve the pinning effect in the AFM pinning layer. The <111> crystal texture also improves the exchange-coupling when an SF layer is used in the MRAM stack. The magnetic seed layer is not utilized in current MRAM fabrication processes as it is easier to use a non-magnetic layer of Ru/Cu/Ta only.

The tunneling barrier 23 layer may be made of aluminum oxide (Al₂O₃), silicon dioxide (SiO₂), tantalum oxide (Ta₂O₅), silicon nitride (SiN₄), aluminum nitride (AlNₓ), or magnesium oxide (MgO). Other dielectrics and certain semiconductor materials may be used for the tunnel barrier layer. The thickness of tunneling barrier layer 23 may range from about 0.5 nanometers to about 3 nanometers.

It is to be understood that the above-referenced arrangements are illustrative of the application for the principles of the present invention. Numerous modifications and alternative arrangements can be devised without departing from the scope of the present invention while the present invention has been shown in the drawings and described above in connection with the exemplary embodiments(s) of the invention. For example, the spin-valve structure is not restricted to memory applications alone. The exact same structure may be used for field sensors and magnetic read heads. Each application will of course require redesign in the tunnel junction characteristics (TMR value, absolute resistance, coercivity, switching field, etc), but such redesign is well within the ability of the skilled artisan with only modest experimentation. It will be apparent to those of ordinary skill in the art that numerous modifications can be made without departing from the principles and concepts of the invention as set forth in the claims.

## Claims

1. A method of developing growth of <111> crystal texture within at least one layer of composition of a magnetic memory cell, the method comprising applying the at least one layer of composition (at least 21-25) within the memory cell (at least 20, 80) with a level of ion energy that is sufficiently high to enable alignment of the at least one layer of composition to a high degree of quality for the <111> crystal texture.

2. The method of claim 1, wherein the level of ion energy that is sufficiently high to enable alignment of the at least one layer of composition to the high degree of quality for the <111> crystal texture is determined by the steps of:
(a) setting (41) the level of ion energy to a predetermined minimum;
(c) applying (42) the at least one layer of composition within the memory cell using the level of ion energy;
(d) measuring (44) a degree of quality for the crystal texture that results from applying the at least one layer of composition using the level of ion energy;
(e) incrementing (45) the level of ion energy to a higher ion energy level by a predetermined amount and repeating from (b) above until a desired ion energy level has been reached; and
(f) setting the level (47) of ion energy approximately to the higher ion energy level used to produce the high degree of quality for the <111> crystal texture within the at least one layer of composition of the magnetic memory cell.

3. The method of claim 1, wherein the magnetic memory cell is a tunneling magneto resistive junction (20, 80).

4. The method of claim 1, wherein at least one of the layers of composition is a synthetic ferrimagnet (50), comprised of at least:
a first ferromagnetic material (51);
a non-magnetic spacer layer (52) fabricated on top of the first ferromagnetic material(51); and
a second ferromagnetic material (53) fabricated on top of the non-magnetic spacer layer and having a magnetic field orientation opposite that of the first ferromagnetic material (51).

5. A method of manufacturing a top-spin valve TMR junction (20) such that a high degree of quality of <111> crystal texture is established within layers of composition of the TMR junction (20), the method comprising:
applying (11) a ferromagnetic sense layer (22) to a seed layer (21);
applying (12) the tunneling barrier layer (23) on the ferromagnetic sense layer (22);
using (13) a level of ion energy for applying a ferromagnetic pinned layer (24) on the tunneling barrier layer (23), wherein the level of ion energy is sufficiently high to facilitate alignment of the ferromagnetic pinned layer (24) to the high degree of quality for the <111> crystal texture; and
applying (14) an antiferromagnetic pinning layer (25) on the ferromagnetic pinned layer (24), developing the <111> crystal texture within the antiferromagnetic pinning layer (25) due to the proximity of the anti ferromagnetic pinning layer (25) to the ferromagnetic pinned layer (24), and due to their similar metallic properties.

6. The method of claim 5, wherein the level of ion energy that is sufficiently high to establish the high degree of quality for the <111> crystal texture within the layers of composition of the TMR junction (20) is determined by the steps of:
(a) setting (41) the level of ion energy to a predetermined minimum;
(b) providing at least the seed layer (21), the ferromagnetic sense layer (22), and the tunneling barrier layer (23);
(c) applying (42) at least the ferromagnetic pinned layer (24) above the tunneling barrier layer (23) using the level of ion energy;
(d) measuring (44) a degree of quality of the crystal texture that results from applying at least the ferromagnetic pinned layer (24) above the tunneling barrier (23) using the level of ion energy;
(e) incrementing (45) the level of ion energy to a higher ion energy level by a predetermined amount and repeating from (b) above until a desired ion energy level has been reached; and
(f) setting (47) the level of ion energy to approximately the higher ion energy level used to produce the high degree of quality for the crystal texture above the tunneling barrier layer (23).

7. The method of claim 5, wherein the ferromagnetic sense layer (22) and/or the ferromagnetic pinned layer (24) are substituted with a synthetic ferrimagnet (50), comprised of at least:
a first ferromagnetic material (51);
a non-magnetic spacer layer (52) fabricated on top of the first ferromagnetic material (51); and
a second ferromagnetic material (53) fabricated on top of the non-magnetic spacer layer (52) and having a magnetic field orientation opposite that of the first ferromagnetic material (51).

8. A method of manufacturing a bottom-spin valve TMR junction (80) such that a high degree of quality of <111> crystal texture is established within layers of composition of the TMR junction (80), the method comprising:
using a level of ion energy for applying an antiferromagnetic pinning layer (25) and a ferromagnetic pinned layer (24) to a seed layer (21), wherein the level of ion energy is sufficiently high to facilitate alignment of the antiferromagnetic pinning layer (25) to the high degree of quality for the <111> crystal texture;
applying the tunneling barrier layer (23) on the ferromagnetic pinned layer (24); and
applying a ferromagnetic sense layer (22) on the tunneling barrier layer (23).

9. The method of claim 8, wherein the level of ion energy that is sufficiently high to enable alignment of the layers of composition of the TMR junction (80) to the high degree of quality for the <111> crystal texture is determined by the steps of:
(a) setting (41) a level of ion energy to a predetermined minimum;
(b) providing a seed layer (21), wherein the seed layer has established the <111> crystal texture;
(c) applying (42) the antiferromagnetic pinning layer (25) and the ferromagnetic pinned layer (24) using the level of ion energy;
(d) applying the tunneling barrier layer (23) and the ferromagnetic sense layer (22) on the ferromagnetic pinned layer (25);
(e) measuring (44) a degree of quality for the <111> crystal texture that results from applying the antiferromagnetic pinning layer (25) and the ferromagnetic pinned layer (24) using the level of ion energy;
(f) incrementing (45) the level of ion energy to a higher ion energy level by a predetermined amount and repeating from (b) above until a desired ion energy level has been reached; and
(g) setting (47) the sufficiently high level of ion energy to the higher ion energy level used to produce the high degree of quality for the <111> within the layers of composition of the TMR junction (80).

10. The method of claim 8, wherein the ferromagnetic sense layer (22) and/or the ferromagnetic pinned layer (24) are substituted with a synthetic ferrimagnet (50), comprised of at least:
a first ferromagnetic material (51);
a non-magnetic spacer layer (52) fabricated on top of the first ferromagnetic material (51); and
a second ferromagnetic material (53) fabricated on top of the non-magnetic spacer layer (52) and having a magnetic field orientation opposite that of the first ferromagnetic material (51).
